Europäisches Patentamt

European Patent Office

Office européen des brevets

(11) Publication number: **0 070 713**
**B1**

(12) **EUROPEAN PATENT SPECIFICATION**

(45) Date of publication of patent specification: **03.05.89**

(21) Application number: **82303755.1**

(22) Date of filing: **16.07.82**

(51) Int. Cl.⁴: **H 01 L 29/32,** H 01 L 29/167,
H 01 L 21/322

(54) **A semiconductor device comprising a bulk-defect region and a process for producing such a semiconductor device.**

(30) Priority: **17.07.81 JP 111864/81**

(43) Date of publication of application:
**26.01.83 Bulletin 83/04**

(45) Publication of the grant of the patent:
**03.05.89 Bulletin 89/18**

(84) Designated Contracting States:
**DE FR GB**

(56) References cited:
**EP-A-0 023 656**
**EP-A-0 030 457**
**US-A-4 116 719**

**IBM JOURNAL OF RESEARCH &
DEVELOPMENT, vol. 24, no. 3, May 1980, New
York, US; H.J. GEIPEL et al.: "Reduction of
leakage by implantation gettering in VLSI
circuits"**

(73) Proprietor: **FUJITSU LIMITED
1015, Kamikodanaka Nakahara-ku
Kawasaki-shi Kanagawa 211 (JP)**

(72) Inventor: **Hiraguchi, Takao
19-1 Aza Suginodou Sakuragawa
Mizusawa-shi, Iwate, 023 (JP)**
Inventor: **Imaoka, Kazunori
Komae-Haitaun 3-304 17 Higashinogawa 3-
chome
Komae-shi Tokyo 201 (JP)**

(74) Representative: **Lawrence, Peter Robin
Broughton et al
GILL JENNINGS & EVERY 53-64 Chancery Lane
London WC2A 1HN (GB)**

## Description

The present invention relates to a semiconductor device, and a process for producing a semiconductor device, wherein the device comprises a semiconductor substrate having a denuded region at an upper surface portion thereof and a bulk defect region beneath the denuded region and a plurality of effective semiconductor elements formed in the denuded region and extending to differing depths from the upper surface of the substrate. Such a device is known from, for instance, EP—A—23656. The denuded region typically is formed by means of an intrinsic gettering, an ion implantation, or a diffusion technique.

By means of the intrinsic gettering technique, a bulk-defect region is selectively formed in a single crystalline silicon wafer produced by means of a pulling method (hereinafter referred to as CZ wafer). The CZ wafer contains oxygen, and a bulk-defect region is selectively formed by precipitating the oxygen as crystal defects in the CZ wafer. More specifically, in the intrinsic gettering technique, the CZ wafer is heat treated at a temperature of 1000°C or higher so as to remove the oxygen contained in the surface portion of the CZ wafer due to out-diffusion of the oxygen. As a result, the surface portion of the CZ wafer has a low oxygen concentration and later becomes a denuded region. Subsequently, the CZ wafer is subjected to a heat treatment at a temperature of approximately 650°C so as to form nuclei in the crystal in the inner part of the CZ wafer. The CZ wafer is next subjected to heat treatment at a temperature of approximately 1050°C so as to transform the nuclei in the crystal into crystal defects. The nuclei in the crystal in the inner part of the CZ wafer are transformed into crystal defects due to the presence of oxygen in the CZ wafer. The oxygen, which is incorporated into the CZ wafer during the manufacture of the wafer, allows nuclei to form in the crystal and to later be transformed into crystal defects. Alledgedly, carbon, which is contained in the CZ wafer, participates during the transformation of the nuclei into crystal defects.

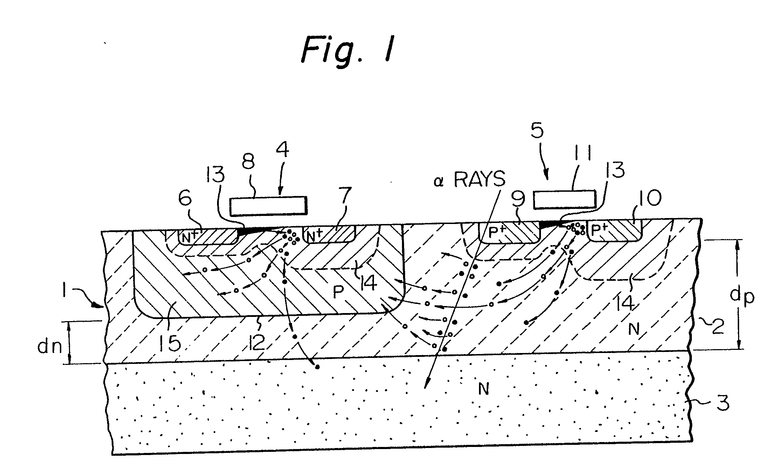

An example of a known semiconductor device which is produced by utilizing the intrinsic gettering technique is hereinafter described with reference to Figure 1.

In the drawings:

Figure 1 illustrates a conventional complementary metal-oxide semiconductor (CMOS) device and the operation thereof;

Figure 2, which is similar to Figure 1, illustrates a CMOS device according to the present invention;

Figures 3 and 4, also similar to Figure 1, illustrate MOS transistors; and

Figures 5 through 8 illustrate processes for producing a semiconductor device according to the present invention. In Figures 5 and 6, the intrinsic gettering technique is utilized to produce a CMOS device and a bipolar semiconductor integrated circuit device, respectively. In Figure 7, an ion implantation or diffusion technique is utilized to produce CMOS semiconductor device, and in Figure 8, the intrinsic gettering technique and an epitaxial growth technique are utilized to produce a semiconductor device.

In the CMOS semiconductor device shown in Figure 1, CZ wafer 1 is comprised of denuded region 2 at the surface portion thereof and bulk-defect region 3 at the inner portion thereof. In the CMOS, N-channel transistor 4 and P-channel transistor 5 are formed in denuded region 2, and P well 15, $N^+$-type source region 6, $N^+$-type drain region 7, gate electrode 8, and a gate insulating film (not shown) are the elements of N-channel transistor 4. Similarly, $P^+$-type source region 9, $P^+$-type drain region 10, gate electrode 11, and a gate insulating film (not shown) are the elements of P-channel transistor 5. The PN junction is marked in Figure 1 as 12.

As is conventional, the depth of the top surface of region 3 is substantially uniform throughout the device and the interface between that region and the denuded region 2 is substantially planar and parallel to the upper surface of the device. For convenience, throughout this specification, we refer to the surface of the device in which, or closest to which, the semiconductor elements 6, 7, 9 and 10 are fitted as the "upper surface" but of course the invention is not limited to any particular geometric positioning of the device.

As a result of the uniform thickness of the surface of region 3 and the parallelism between the upper surface of the device and the interface between the denuded region and the bulk defect region it follows that the thickness of the denuded region varies according to the thickness of the semiconductor elements located in it.

Observation of such devices during use has revealed that a leak current appears to be generated in the PN junction and that this can give rise to various undesirable defects. As explained in more detail below it can give rise to noise, latch up problems when the transistors are miniaturised, refresh failure, and incomplete isolation of the semiconductor elements.

The problem behind the invention is to minimise or eliminate some or all of these difficulties.

One of the reasons for forming N-channel transistor 4 and P-channel transistor 5 of the CMOS in denuded region 2 is that contaminant substances, which may be incorporated into denuded region 2 through the surface thereof during the production of a CMOS, can be captured by bulk-defect region 3 with the result that the properties of N-channel transistor 4 and P-channel transistor 5, especially the junction property, are stabilised. Another reason for forming transistors 4 and 5 is that electron-hole pairs which are generated due to α-rays are captured in bulk-defect region 3.

The present inventors studied the electrical properties of conventional CMOSs and discovered that since the distance (dp) between bulk-defect region 3 and either $P^+$-type source region 9 or P$^+$-type drain region 10 of the CMOS is greater than the distance (dn) between bulk-defect region 3 and P well 15 of the CMOS, various problems result. One of the problems is that when α-rays are emitted into CZ wafer 1, pairs of electrons (black dots) and holes (white dots), i.e. electron-hole pairs are generated and several holes then diffuse toward P well 15. Since the diffusion length of the electron-hole pairs is long in denuded region 2 due to the absence of crystal defects, it is highly possible that diffusion of the holes toward P well 15 mentioned above can generate a leak current in PN junction 12, which is formed between P well 15 and denuded region 2, denuded region 2 having an N-type conductivity. A leak current can cause noise.

Hereinafter, N-channel transistor 4 and P-channel transistor 5 are collectively referred to as MOS transistors 4 and 5.

Another problem is that when inversion layers 13 are formed during energisation of MOS transistors 4 and 5, electron-hole pairs are generated, due to impact ionisation, in depletion layer 14 around N$^+$-type drain region 7 or P$^+$-type drain region 10, and the electrons and/or holes then move toward the surface of CZ wafer 1. During this movement, no recombination of the holes and electrons occurs in bulk-defect region 3 due to the fact that dp>dn. Instead, an inflow of holes into P well 15 occurs, causing the potential of P well 15 to increase, and, as a result a leak current can be generated in PN junction 12. The generation of a leak current becomes serious when MOS transistors 4 and 5 are miniaturised, and a so-called latch up frequently occurs during energisation of the CMOS. Reference numeral 14 indicates schematically depletion layers which are formed around the sources and drains of MOS transistors 4 and 5 due to the PN junctions, which are not numbered.

The present inventors generally noted the following points concerning a conventional semiconductor device:

1) In a conventional semiconductor device, at least two semiconductor elements have a nonuniform depth when measured from the surface of the semiconductor substrate and the denuded region and the bulk-defect region of said semiconductor device have a uniform depth when measured from the surface of the semiconductor substrate; 2) For this reason, a leak current can be generated in the PN junction of a semiconductor device; 3) Due to the possible generation of a leak current, the information holding time is shortened and refresh failure thus results in the case of a dynamic memory semiconductor device; 4) Due to the leak current, isolation of the semiconductor elements becomes incomplete in the case of bipolar semiconductor integrated circuit device when such device is highly integrated.

A semiconductor device according to the invention comprises a semiconductor substrate having a denuded region at an upper surface portion thereof and a bulk-defect region beneath the denuded region and a plurality of effective semiconductor elements formed in the denuded region and extending to differing depths from the upper surface of the substrate, and the device is characterised in that the upper surface of the bulk-defect region is profiled in response to the lower profile of the effective semiconductor elements so that variations in the thickness of the denuded layer between the elements and the bulk-defect region are less than if the bulk-defect region had a substantially planar upper surface. Preferably the thickness of the denuded layer between each effective element and the adjacent bulk-defect region is substantially uniform. By saying that it is substantially uniform we mean that any variations in the distance between the bulk-defect layer and the effective semiconductor elements are sufficiently small that the aforesaid disadvantages are minimised or eliminated. There may be no variation or the variation may be as great as may be measured on the accompanying drawings (even though they are otherwise diagrammatic) or may be larger. The denuded layer may be any effective layer for holding the elements and that is substantially free of bulk defects.

The depth measured from the surface of the semiconductor substrate is hereinafter simply referred to as the depth.

The described lower profile of the effective semiconductor elements may be provided by the lower profile of an actual element that is formed in the device during manufacture or it may be defined by a depletion layer formed during use. Preferably one of the effective semiconductor elements is a P or N well or a buried P or N collector and the upper surface of the bulk-defect region is downwardly profiled beneath the well or collector.

A semiconductor element, for instance a P-channel transistor, is often formed of two or more components and these components may extend to differing depths beneath the surface of the substrate, in which event it is preferred that the upper surface of the bulk-defect region should also be profiled in response to this profiling within a single element. It is often preferred that one of the effective semiconductor elements should be defined by the lower limit of the depletion layer which does extend to varying depths beneath the surface of the device and it is then desirable that the upper surface of the bulk-defect region should additionally be profiled in response to the profile of the depletion layer beneath the components of the semiconductor element.

A semiconductor device is generally constructed such that any one of the semiconductor elements is one of a pair of regions having differing types of conductivity and which form a PN junction. The depth of the bulk-defect region may then be determined in accordance with the depth of the active region to which carriers flow from one or more of the semiconductor elements during energisation of the semiconductor device.

The semiconductor elements may be bipolar transistors. The may be MOS transistors and the depth of the bulk-defect region below the drain region of each MOS transistor may be less than that below the source region of each MOS transistor. The MOS transistors may be CMOS transistors, each comprising a P wall or an N well.

Any one of said plurality of semiconductor elements is, generally speaking, one of a pair of regions having different types of conductivity and forming a PN junction, i.e. a fundamental element of a semiconductor device. In an ordinary semiconductor device, a plurality of pairs of said regions is functionally combined so as to produce active or passive semiconductor elements. The bulk-defect region of the present invention has, therefore, a depth which is nonuniform in accordance with the depth of the active or passive semiconductor elements. In addition, since the electrical properties of a semiconductor device being energised are most influenced by the active region, to which region the carriers flow from one or more of the semiconductor elements, e.g. the passive or active semiconductor elements, the bulk-defect region of the present invention preferably has a depth which is nonuniform in accordance with the depth of the active region. The depth of the bulk-defect region is preferably determined in accordance with the depth of a depletion layer which is formed around the passive or active semiconductor elements. Specifically, in the case of a bipolar semiconductor integrated circuit device, all of the bipolar transistors (active semiconductor elements) are isolated from each other by isolation regions which are inactive. In this case, the bulk-defect region of the present invention preferably has a depth which is nonuniform in accordance with the depth of the bipolar transistors and the isolation regions.

The invention includes a process for producing a semiconductor device comprising a semiconductor substrate having a denuded region at an upper surface portion thereof, in which is formed a plurality of semiconductor elements having a depth which is non-uniform when measured from the surface of the substrate, and a bulk defect region beneath the denuded region. The process comprises a step for selectively forming in the substrate a bulk-defect region having a high oxygen concentration and a depth measured from the surface of the semiconductor substrate that is non-uniform following the intended non-uniform depth profile of the semiconductor elements, and forming the semiconductor elements above the bulk-defect region. The bulk defect region is formed preferably by means of the intrinsic gettering technique or the ion implantation or diffusion technique.

The intrinsic gettering technique may be used to selectively form a bulk-defect region in a semiconductor substrate comprising a CZ wafer. In a case where a semiconductor substrate comprises a single crystalline semiconductor wafer produced by a floating zone method (hereinafter referred to as an FZ wafer), the ion implantation or diffusion technique is used to selectively form a bulk-defect region since the FZ wafer has a low concentration of oxygen and oxygen must be incorporated into the FZ wafer.

Embodiments of the present invention are hereinafter described.

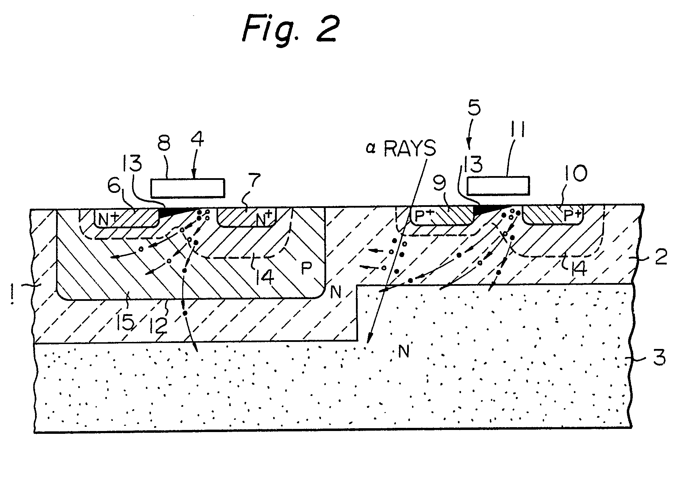

In Figure 2, a CMOS of the present invention is shown. A CMOS usually comprises a P well or N well, and in Figure 2, a CMOS comprising P well 15 is shown. The semiconductor elements are N-channel transistor 4 and P-channel transistor 5. The effective depth of N-channel transistor 4 is determined by the depth of P well 15 while the effective depth of P-channel transistor 5 may be determined by the depth of $P^+$-type source region 9 and $P^+$-type drain region 10. The depth of the upper surface of the bulk-defect region 3 is therefore large beneath N-channel transistor 4 and is small beneath P-channel transistor 5. The profiling of the upper surface of the bulk-defect layer results in the distance between the elements and the layer being more uniform than would otherwise be the case. As a result the electron hole pairs, which may be generated in denuded region 2 upon the emission of α-rays, can be effectively captured in bulk-defect region 3, and recombination of the electron-hole pairs effectively occurs in bulk-defect region 3. The electrons which may be generated due to impact ionisation can also be effectively captured in bulk-defect region 3. Therefore, it is possible to prevent the occurrence of latch up and the generation of a leak current in PN junction 12.

The electrical import of the depth of the semiconductor elements, such as P-channel transistor 5, is determined based on the depth of depletion layer 14 formed around P-channel transistor 5. The depth determined by depletion layer 14 is hereinafter referred to as the effective depth. The depth of bulk-defect region 3 below the semiconductor elements, such as P-channel transistor 5, is preferably determined in accordance with the effective depth of, for example, P-channel transistor 5.

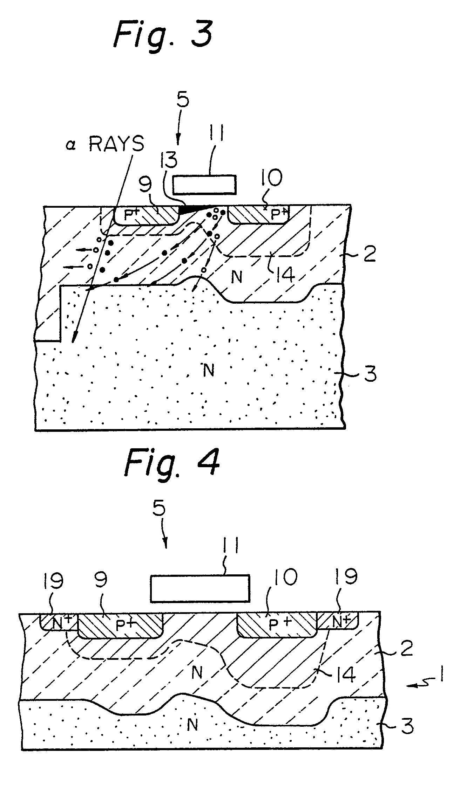

An example of bulk-defect region 3, the depth of which is determined in accordance with the effective depth of P-channel transistor 5, is shown in Figure 3. The upper surface of the bulk-defect region 3 is shallow and deep beneath $P^+$-type source region 9 and $P^+$-type drain region 10, respectively, of P-channel transistor 5.

In Figure 4, P-channel transistor 5 provided with $N^+$-type isolation region 19 is shown. The depth of bulk-defect region 3 is determined in accordance with the effective depth of P-channel transistor 5 and the depth of $N^+$-type isolation region 19.

As can be understood from the description hereinabove, determination of the depth of the bulk-defect region in accordance with the depth or effective depth of the semiconductor elements can be said to involve a concept in which, as seen in a cross-section of semiconductor device, the bulk-defect region is provided with an upper profile which is substantially the same as the lower profile of the semiconductor elements. Preferably, the distance between the bulk-defect region and the depletion layer is determined so that the distance between the bulk-defect region and the deepest portion of the depletion layer is from 2 to 30 μm, the deepest portion of the depletion layer implying that the depletion layer spreads when a predetermined voltage is applied to the semiconductor elements.

The precipitation of crystal defects can be achieved not only by means of the intrinsic gettering technique but also by means of the ion implantation or diffusion technique. The concentration of oxygen in a CZ or FZ wafer necessary for precipitation is desirably approximately $1.6 \times 10^{18}/cm^3$.

The bulk-defect region of the present invention can be used in any bipolar or MOS semiconductor integrated circuit device. In any case, the bulk-defect region does not protrude through the PN junction of a such device.

Embodiments of the process according to the present invention are hereinafter described.

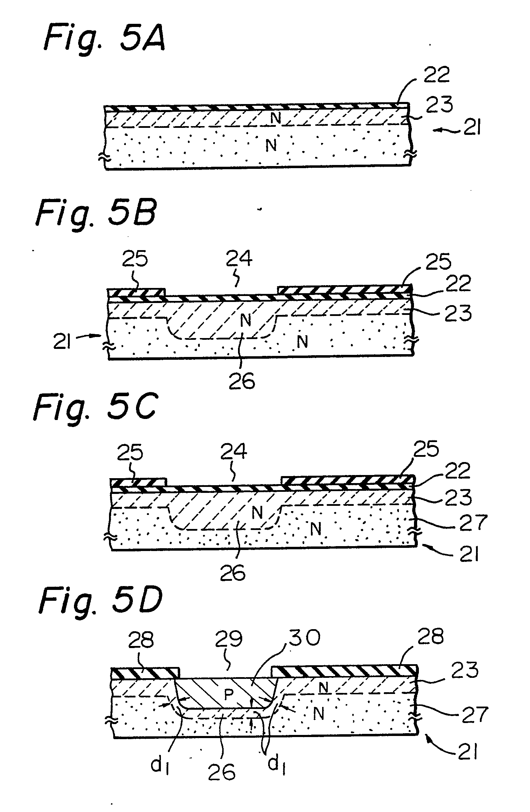

In Figs. 5A through 5G, a semiconductor device, i.e., a CMOS, is produced by means of an embodiment of the process according to the present invention $N^-$-type silicon substrate 21 comprises a CZ wafer and is subjected to conventional thermal oxidation so as to form first silicon dioxide film 22 having a thickness of, for example, from 50 to 60 nm (500Å to 600Å). $N^-$-type silicon substrate 21 is then heat treated at a temperature of from 1050°C to 1150°C for 10-minute period within a non-oxidizing atmosphere, such as a nitrogen atmosphere, so as to out-diffuse an impurity, such as oxygen, contained in the surface portion of $N^-$-type silicon substrate 21. The above-mentioned heat treatment at a temperature of from 1050°C to 1100°C is hereinafter referred to as a first high-temperature treatment. As a result of the first high-temperature treatment, low oxygen concentration region which becomes later first denuded region 23 is formed beneath first silicon dioxide film 22 and has a thickness of approximately 8 μm.

Subsequently, silicon nitride film 25 (Fig. 5B) is formed by means of a conventional chemical vapor deposition (CVD) method on first silicon dioxide film 22, which is formed on $N^-$-type silicon substrate 21, and then delineated by means of a conventional photoetching method. Silicon nitride film 25 has preferably a thickness of from 100 to 200 nm (1000Å to 2000Å) so that it is highly resistant to oxidation. As a result of delineation of silicon nitride film 25, window 24 selectively exposes first silicon dioxide film 22, and a P well (not shown) is formed beneath film 22. After the delineation of the silicon nitride film, $N^-$-type silicon substrate 21 is heat treated at a temperature of from 1050°C to 1150°C for a few hours within a non-oxidizing atmosphere so as to out-diffuse an impurity, such as oxygen, contained in $N^-$-type silicon substrate 21. This heat treatment is hereinafter referred to as a second high-temperature treatment. As a result of the second high-temperature treatment, low oxygen concentration region which later becomes second denuded region 26 having a depth of, for example 15 μm is formed.

Subsequently, $N^-$-type silicon substrate 21 (Fig. 5C) is heat treated at a temperature which is lower than that of the first and second high-temperature treatments, for example, from 550°C to 900°C, for an optional period of time. This heat treatment is hereinafter referred to as a low-temperature treatment. As a result of the low-temperature treatment, excess oxygen, which is contained in the portion of $N^-$-type silicon substrate 21 other than low oxygen concentration regions which later become first and second denuded regions 23 and 26, respectively, is coagulated and precipitated, and bulk-defect region 27, which is contiguous to first and second denuded regions 23 and 26, respectively, is formed.

Silicon nitride film 25 (Fig. 5C) is then selectively removed and thermal oxidation is carried out at a temperature, for example, 900°C lower than the first and second high-temperature treatments so as to form on $N^-$-type silicon substrate 21 second silicon dioxide film 28 (Fig. 5D) having a thickness of, for example, 500 nm (5000Å). Window 29 for P well diffusion is then formed by means of a conventional photoetching method through second silicon dioxide film 28. A P-type impurity is diffused through window 29 for P well diffusion by means of a conventional gas diffusion method or the like so as to form in second denuded region 26 P well 30 having a predetermined impurity concentration. P well 30 is adjacent to bulk-defect region 27 but a distance $(d_1)$ of from 5 to 6 μm is maintained between the boundary surfaces of P well 30 and bulk-defect region 27.

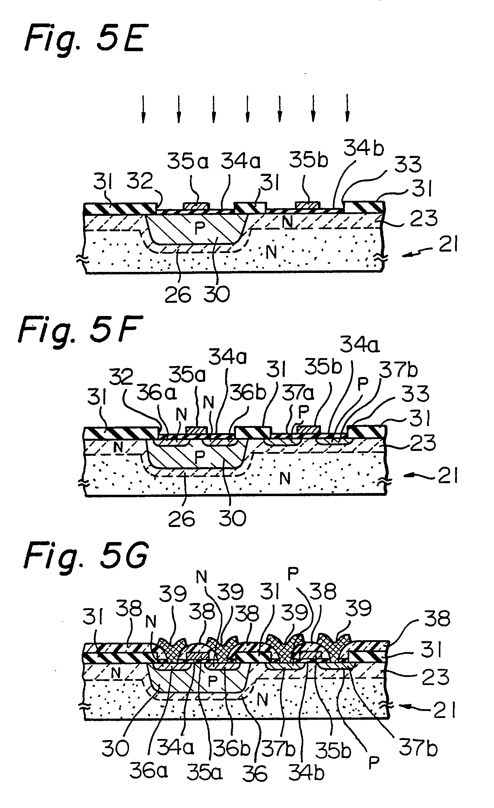

The following steps illustrated in Figs. 5E through 5G are carried out in accordance with a conventional process for producing a CMOS.

In Fig. 5E, after removing second silicon dioxide film 28 (not shown), which is formed on $N^-$-type silicon substrate 21, third silicon dioxide film 31 having a thickness of, for example, 500 nm (5000Å) is formed on $N^-$-type silicon substrate 21, by means of a conventional thermal oxidation method, at a temperature of 900°C or lower. Window 32 for producing an N-channel transistor and window 33 for producing a P-channel transistor are formed through third silicon dioxide film 31. Gate oxide films 34a and 34b are formed on exposed P well 30 and exposed $N^-$-type silicon substrate 21, respectively, by means of a conventional thermal oxidation method. The thickness of gate oxide films 34a and 34b is on the order of 10 nm (100Å). Polycrystalline silicon gate electrodes 35a and 35b are then formed on gate oxide films 34a and 34b, respectively, by depositing on films 34a and 34b a polycrystalline silicon layer having a thickness of from approximately 300 to 400 nm (3000Å to 4000Å) and then delineating the polycrystalline silicon layer. Deposition and delineation of the polycrystalline silicon layer are carried out by a CVD method and a photoetching method, respectively. A photoresist film (not shown) is then applied over window 33 to produce an N-channel transistor. While such photoresist film is being applied, an N-type impurity, for example, arsenic, in diffused or ion implanted into portions of P well 30 which are not covered by polycrystalline silicon gate electrode 35a so that the diffusion or ion implantation depth becomes, for example, from 200 to 300 nm (2000Å to 3000Å). Subsequently, a photoresist film (not shown) is applied over window 32 for producing a P-channel transistor. While this photoresist film is being applied, a P-type impurity, for example, boron, is diffused or ion implanted into portions of N-type silicon substrate 21 which are not covered by polycrystalline silicon gate electrode 35b so that the diffusion or ion implantation depth becomes, for example, from 200 to 300 nm (2000Å to 3000Å). In the case of ion implantation, the impurity is activated by heat treatment at a temperature of approximately 950°C. As a result of the diffusion or ion implantation described hereinabove, N-type source region 36a and N-type drain region 36b, respectively, of an N-channel transistor are formed in P well 30 while P-type source regions 37a and P-type drain region 37b, respectively, of a P-channel transistor are formed in first denuded region 23. The PN junctions between N⁻-type silicon substrate 21 and P-type source region 37a and P-type drain region 37b, respectively, are formed in first denuded region 23.

In Fig. 5G, the production of a CMOS is completed by successively forming insulating film 38 consisting of phosphosilicate glass (PSG), opening windows through insulating film 38, and forming electrodes and conductors 39 consisting of aluminum.

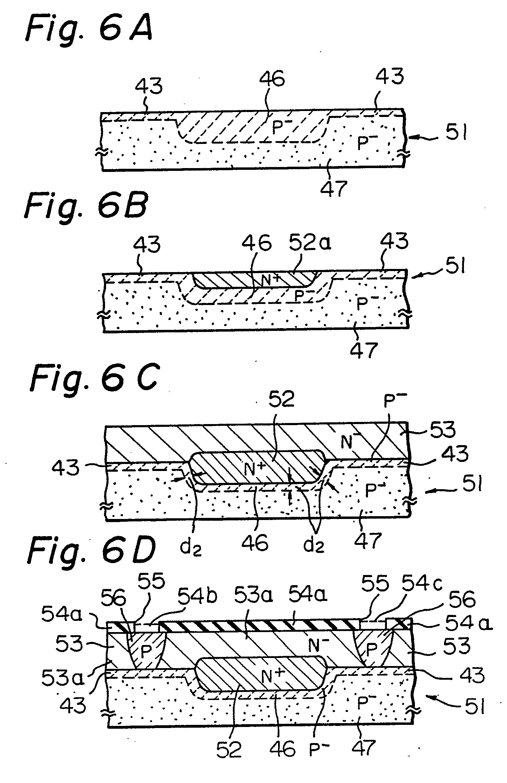

In Figs. 6A through 6G, a bipolar semiconductor integrated circuit device, i.e., an NPN-type bipolar transistor, is produced by means of an embodiment of the process according to the present invention.

First, as is illustrated in Figs. 6A through 6C, first denuded region 43 having a depth of, for example, from 3 to 4 μm and second denuded region 46 having a depth of, for example, 10 μm are formed in P⁻-type silicon substrate 51. In addition, bulk-defect region 47, which is contiguous to first and second denuded regions 43 and 46, respectively, is formed in P⁻-type silicon substrate 51. The lateral dimension of second denuded region 46 is determined so that N⁺-type buried collector region 52 (Figs. 6C through 6G) can be formed in second denuded region 46.

The following steps illustrated in Figs. 6B through 6G are carried out in accordance with a conventional process for producing an NPN-type bipolar transistor.

In Fig. 6B, an N-type impurity, such as arsenic or antimony, is selectively diffused or is ion implanted in second denuded region 46 so as to form N⁺-type region 52a.

Subsequently, N⁻-type epitaxial silicon layer 53 (Fig. 6C) having a thickness of from 5 to 6 μm is formed on the P⁻-type silicon substrate so that N⁺-type region 52a is covered by N⁻-type epitaxial silicon layer 53. Since the epitaxial growth of N⁻-type epitaxial silicon layer 53 is carried out at high temperature of from approximately 1100°C to 1150°C, N⁺-type buried collector region 52 is formed due to upward diffusion of the impurity from N⁺-type region 52a. N⁺-type buried collector region 52 is preferably separated from bulk-defect region 47 so that the distance (d₂) of the PN junction, located between P⁻-type silicon substrate 51 and N⁺-type buried collector region 52, from the top surface of bulk-defect region 47 is from 5 to 6 μm. Such distance can be ensured by appropriately determining the depth of N⁺-type region 52a (Fig. 6B).

In Fig. 6D, silicon dioxide film 54 is formed on N⁻-type epitaxial silicon layer 53 by means of a conventional method, and windows 55 for producing isolation regions are formed through silicon dioxide film 54a. Through windows 55, a P-type impurity, for example boron, is diffused by means of a conventional gas diffusion method so as to form P⁺-type isolation regions 56 in N⁻-type epitaxial silicon layer 53, regions 56 defining and isolating a plurality of N⁻-type collector regions 53a from each other. During the formation of P⁺-type isolation regions 56, silicon dioxide films 54b and 54c are formed in P⁺-type isolation regions 56.

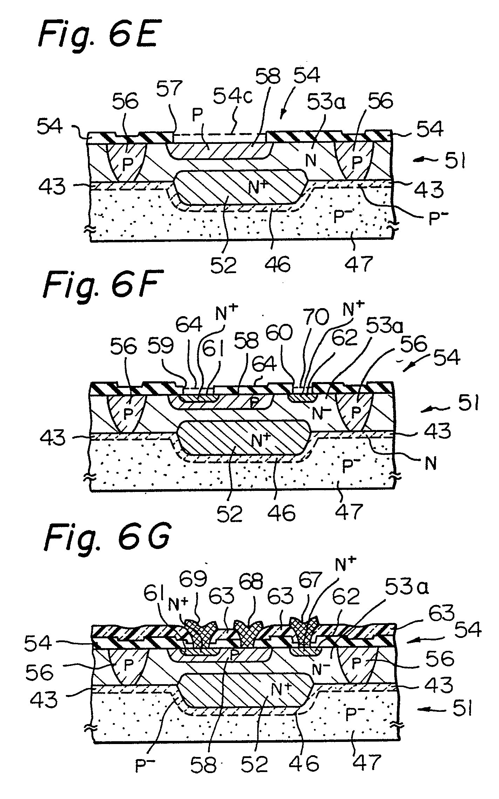

Window 57 (Fig. 6E) for base diffusion is formed through silicon dioxide film 54a by means of a conventional photoetching method. A P-type impurity, for example, boron, is diffused through window 57 for base diffusion by means of a conventional gas diffusion method so as to form in N⁻-type collector regions 53a P-type base regions 58 having a predetermined depth and impurity concentration while silicon dioxide film 54c is formed in each of P-type base regions 58.

Window 59 for emitter diffusion and window 60 for collector-contact diffusion are formed through silicon dioxide films denoted collectively by 54 by means of a conventional photoetching method. An N-type impurity, for example, phosphorus or arsenic, is introduced through windows 59 and 60 by means of a conventional gas diffusion method or the conventional ion implantation technique, followed by the activation of phosphorus or arsenic, so as to form N⁺-type emitter region 61 in each of P-type base regions 58 and N⁺-type collector-contact region 62 in each of N⁻-type collector regions 53a. During the formation of N⁺-type emitter region 61 and N⁺-type collector-contact region 62, silicon dioxide film 64 is formed in each of these regions.

Passivation film 63 consisting of a phosphosilicate glass (PSG) is formed on P⁻-type silicon substrate 51 and then windows (not shown) for producing the collector, base and emitter electrodes are formed through passivation film 63. The collector electrode and conductor 67, the base-electrode and conductor 68, and the emitter-electrode and conductor 69 are then formed in such a manner that an end of each of these electrodes and conductors is positioned in each of the windows (not shown) mentioned above.

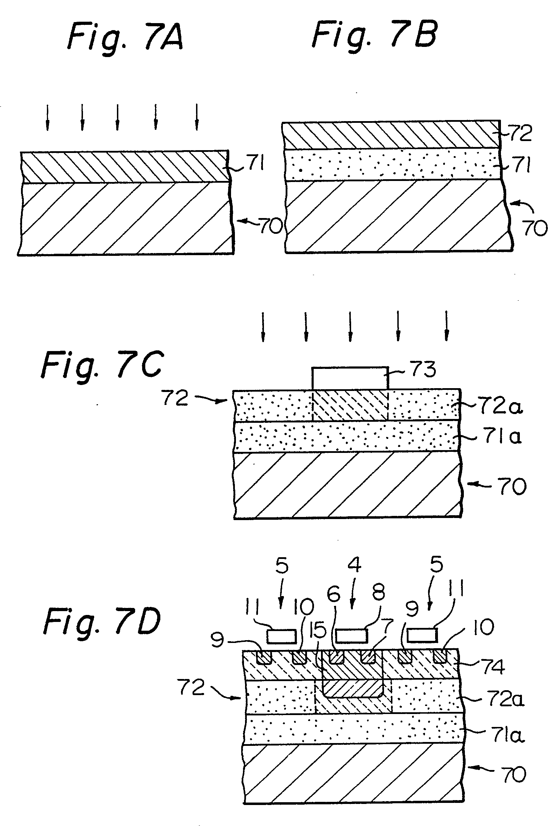

In Figs. 7A through 7D, a CMOS having a nonuniform deep bulk-defect region is produced by an embodiment of the process of the present invention, in which embodiment the ion implantation or diffusion technique is utilized. On the surface portion of FZ wafer 70 (Fig. 7A), high-oxygen concentration region 71 is formed by means of the ion implantation or diffusion technique. High-oxygen concentration region 71 preferably has a thickness of from 5 to 10 μm and an oxygen concentration of from 1.4 to $1.9\times10^{18}/$ cm$^3$.

Epitaxial silicon layer 72 (Fig. 7B) having a thickness of from 7 to 8 μm is formed on high-oxygen concentration region 71. Photoresist film 73 (Fig. 7C) is then selectively formed on epitaxial silicon layer 72 and high-oxygen concentration epitaxial silicon region 72a is selectively formed by means of the ion implantation technique. Instead of this, the oxygen may be selectively diffused to form high-oxygen concentration epitaxial silicon region 72a. Subsequently, heat treatment is carried out at a temperature of from 550°C to 900°C so as to precipitate the oxygen as crystal defects. As a result of the precipitation of oxygen, high-oxygen concentration region 71 is converted to bulk-defect region 71a, and in epitaxial silicon layer 72 bulk-defect region which is also denoted by 72a is selectively formed. Therefore, bulk-defect regions 71a and 72a having a nonuniform depth are formed. Subsequently, epitaxial silicon layer 74 having a thickness of from 7 to 8 μm is formed on epitaxial silicon layer 72.

The known procedures for the production of a CMOS are then carried out so that a CMOS (Fig. 7D), the parts of which are denoted by the same reference numerals as in Figs. 1 and 2, is obtained.

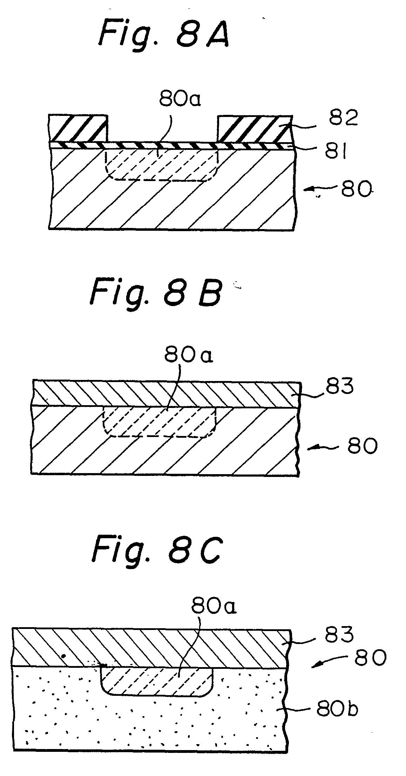

In Fig. 8A, silicon dioxide film 81 and silicon nitride film 82 are successively formed on CZ wafer 80 and a heat treatment is then carried out at a temperature of from 1050°C to 1150°C so as to selectively out-diffuse the oxygen contained in CZ wafer 80 and thus form low-oxygen concentration region 80a. Epitaxial silicon layer 83 (Fig. 8B) having a thickness of from 7 to 8 μm is formed on CZ wafer 80. Subsequently, a heat treatment is carried out at a temperature of from 550°C to 900°C so as to form bulk-defect region 80b. The procedures illustrated in Figs. 5 or 6 are then carried out so that a CMOS or an NPN transistor is produced.

As shown in Figs. 6 through 8, when ion implantation or diffusion is carried out twice, the bulk-defect layer has two different depths. Therefore, when ion implantation or diffusion is carried out three or more times, the bulk-defect layer has three or more different depths.

## Claims

1. A semiconductor device comprising a semiconductor substrate (1, 21, 51, 70, 80) having a denuded region (2, 23, 26, 43, 46, 80a) at an upper surface portion thereof and a bulk-defect region (3, 27, 47, 71a, 72a, 80b) beneath the denuded region and a plurality of effective semiconductor elements (4, 5, 9, 10, 14, 15, 30, 52, 56) formed in the denuded region and extending to differing depths from the upper surface of the substrate, characterised in that the upper surface of the bulk-defect region is profiled in response to the lower profile of the effective semiconductor elements so that variations in the thickness of the denuded layer between the elements and the bulk-defect region are less than if the bulk-defect region has a substantially planar upper surface.

2. A device according to claim 1 characterised in that the thickness of the denuded layer between each effective element and the adjacent bulk-defect region is substantially the same.

3. A device according to either preceding claim characterised in that one of the effective semiconductor elements is a P or N well (15, 30) or a buried P or N collector (52) and the upper surface of the bulk-defect region is downwardly profiled beneath the well or collector.

4. A device according to any preceding claim characterised in that the lower profile of an effective semiconductor element (5) is defined by the depletion layer (14) formed beneath the element.

5. A device according to claim 4 characterised in that the depletion layer extends to a varying depth beneath the element and the upper surface of the bulk-defect region is profiled in response to the profile of the depletion layer.

6. A device according to claim 4 or claim 5 characterised in that the distance between the bulk-defect region and the deepest portion of the depletion layer is from 2 to 30 μm.

7. A device according to any preceding claim characterised in that at least one of the effective semiconductor elements is one of a pair of regions having different types of conductivity and which form a PN junction.

8. A device according to claim 7 characterised in that the depth of the bulk-defect region is determined in accordance with the depth of the active region to which carriers flow from one or more of the semiconductor elements during energisation of the semiconductor device.

9. A device according to any preceding claim characterised in that the semiconductor elements are bipolar transistors, preferably comprising buried collector regions.

10. A device according to any preceding claim in which the semiconductor elements are MOS transistors having a drain region and a source region wherein the depth of the bulk-defect region below the drain region is less than below the source region and wherein preferably the MOS transistors are CMOS transistors each comprising a P well or an N well.

11. A process for producing a semiconductor device comprising a semiconductor substrate (1, 21, 51, 70, 80) having a denuded region (2, 23, 26, 43, 46, 80a) at an upper surface portion thereof, in which is formed a plurality of effective semiconductor elements (4, 5, 9, 10, 14, 15, 30, 52, 56) extending to differing depths from the upper surface of said semiconductor substrate and a bulk defect region (3, 27, 47, 71a, 72a, 80b) beneath the denuded region, said process comprising a step for selectively forming in the substrate said bulk-defect region having a high-oxygen concentration and a depth measured from the surface of the semiconductor substrate that is non-uniform following the intended non-uniform depth profile of the semiconductor elements and forming the semiconductor elements above the bulk-defect region.

12. A process according to claim 11 characterised in that the semiconductor substrate comprises a CZ wafer (1, 21) and the step for selectively forming a bulk-defect region comprises out-diffusing oxygen contained in the CZ wafer by means of the intrinsic gettering technique.

13. A process according to claim 12, characterised in that the out-diffusion of oxygen is carried out by using a mask consisting of a nitride film (25), for selectively exposing a portion of said CZ wafer (21), and the bulk-defect region (26) is formed in that portion.

14. A process according to claim 11 characterised in that the semiconductor substrate comprises a FZ wafer (70) and said step for selectively forming a bulk-defect region (71a, 72a) comprises ion implanting or diffusing oxygen into the FZ wafer.

**Patentansprüche**

1. Halbleitervorrichtung mit einem Halbleitersubstrat (1, 21, 51, 70, 80), das einen entblößten Bereich (2, 23, 26, 43, 46, 80a) an seinem oberen Oberflächenabschnitt und einen Grundmaterial-Defekt-Bereich (3, 27, 47, 71a, 72a, 80b) unterhalb des entblößten Bereiches und eine Vielzahl von effektiven Halbeiterelementen (4, 5, 9, 10, 14, 15, 30, 52, 56) hat, die in dem entblößten Bereich gebildet sind und sich in verschiedene Tiefen von der oberen Oberfläche des Substrates erstrecken, dadurch gekennzeichnet, daß die obere Oberfläche des Grundmaterial-Defekt-Bereichs profiliert ist, in Abhängigkeit von dem unteren Profil der effektiven Halbleiterelemente, so daß Veränderungen in der Dicke der entblößten Schicht zwischen den Elementen und dem Grundmaterial-Defekt-Bereich kleiner sind, als wenn der Grundmaterial-Defekt-Bereich eine im wesentlichen planare obere Oberfläche hat.

2. Vorrichtung nach Anspruch 1, dadurch gekennzeichnet, daß die Dicke der entblößten Schicht zwischen jedem effektiven Element und dem benachbarten Grundmaterial-Defekt-Bereich im wesentlichen dieselbe ist.

3. Vorrichtung nach einem der vorhergehenden Ansprüche, dadurch gekennzeichnet, daß eines der effektiven Halbleiterelemente ein P- oder N-Topf (15, 30) oder ein vergrabener P- oder N-Kollektor (52) ist und die obere Oberfläche des Grundmaterial-Defekt-Bereichs unterhalb des Topfes oder Kollektors nach unten profiliert ist.

4. Vorrichtung nach einem der vorhergehenden Ansprüche, dadurch gekennzeichnet, daß das untere Profil eines effektiven Halbleiterelementes (5) durch die Verarmungsschicht (14) begrenzt ist, die unterhalb des Elements gebildet ist.

5. Vorrichtung nach Anspruch 4, dadurch gekennzeichnet, daß die Verarmungschicht sich in verschiedene Tiefen unterhalb des Elementes erstreckt und die obere Oberfläche des Grundmaterial-Defekt-Bereichs in Abhängigkeit von dem Profil der Verarmungsschicht profiliert ist.

6. Vorrichtung nach Anspruch 4 oder 5, dadurch gekennzeichnet, daß der Abstand zwischen dem Grundmaterial-Defekt-Bereich und dem tiefsten Abschnitt der Verarmungsschicht zwischen 2 bis 30 µm beträgt.

7. Vorrichtung nach einem der vorhergehenden Ansprüche, dadurch gekennzeichnet, daß wenigstens eines der effektiven Halbleiterelemente eines von einem Paar von Bereichen ist, welche verschiedene Arten von Leitfähigkeit aufweisen, und welche einen PN-Übergang bilden.

8. Vorrichtung nach Anspruch 7, dadurch gekennzeichnet, daß die Tiefe des Grundmaterial-Defektbereichs in Übereinstimmung mit der Tiefe des aktiven Bereichs bestimmt ist, zu welchem während der Erregung der Halbleitervorrichtung Träger von einem oder mehreren Halbleiterelementen fließen.

9. Vorrichtung nach einem der vorhergehenden Ansprüche, dadurch gekennzeichnet, daß die Halbleiterelemente bipolar Transistoren sind, vorzugsweise mit vergrabenen Kollektorbereichen.

10. Vorrichtung nach einem der vorhergehenden Ansprüche, bsi welcher die Halbleiterelemente MOS-Transistoren sind, die einen Drain-Bereich und einen Source-Bereich haben, bei welcher die Tiefe des Grundmaterial-Defekt-Bereichs unterhalb des Drain-Bereichs geringer als unterhalb des Source-Bereichs ist und bei welcher vorzugsweise die MOS-Transistoren CMOS-Transistoren sind, die jeweils einen P-Topf oder N-Topf aufweisen.

11. Verfahren zur Herstellung einer Halbleitervorrichtung mit einem Halbleitersubstrat (1, 21, 51, 70, 80), das einen entblößten Bereich (2, 23, 26, 43, 46, 80a) an seiner oberen Oberfläche aufweist, bei welchem eine Vielzahl von effektiven Halbleiterelementen (4, 5, 9, 10, 14, 15, 30, 52, 56), die sich in verschiedene Tiefen von der oberen Oberfläche des genannten Halbleitersubstrats erstrecken, und ein Grundmaterial-Defekt-Bereich (3, 27, 47, 71a, 72a, 80b) unterhalb des entblößten Bereiches gebildet werden, welches Verfahren einen Schritt zur selektiven Bildung, in dem Substrat, des genannten Grundmaterial-Defekt-Bereiches umfaßt, der eine hohe Sauerstoffkonzentration und eine Tiefe hat, gemessen von der Oberfläche des Halbleitersubstrats, die ungleichmäßig ist, folgend dem beabsichtigten ungleichförmigen Tiefenprofil der Halbleiterelemente, und Bilden der Halbleiterelemente oberhalb des Grundmaterial-Defekt-Bereichs.

12. Verfahren nach Anspruch 11, dadurch gekennzeichnet, daß das Halbleitersubstrat einen CZ-Wafer (1, 21) umfaßt und der Schritt zum selektiven Bilden des Grundmaterial-Defekt-Bereichs das Ausdiffundieren von Sauerstoff, welches in dem CZ-Wafer enthalten ist, mittels der eigenleitenden Gettertechnik umfaßt.

13. Verfahren nach Anspruch 12, dadurch gekennzeichnet, daß das Ausdiffundieren von Sauerstoff unter Verwendung einer Maske durchgeführt wird, die aus einem Nitridfilm (25) besteht, um selektiv einen Abschnitt des genannten CZ-Wafers (21) zu exponieren, und der Grundmaterial-Defekt-Bereich (26) in jenem Abschnitt gebildet wird.

14. Verfahren nach Anspruch 11, dadurch gekennzeichnet, daß das Halbleitersubstrat einen FZ-Wafer (70) umfaßt und der genannte Schritt der selektiven Bildung eines Grundmaterial-Defekt-Bereiches (71a, 72a) das Ionenimplantieren oder Diffundieren von Sauerstoff in den FZ-Wafer umfaßt.

**Revendications**

1. Dispositif à semi-conducteur comprenant un substrat semi-conducteur (1, 21, 51, 70, 80) ayant une région dénudée (2, 23, 26, 43, 46, 80a) formée dans une partie de sa surface supérieure et une région à défauts en volume (3, 27, 47, 71a, 72a, 80b) placée au-dessous de la région dénudée, et plusieurs éléments actifs à semi-conducteurs (4, 5, 9, 10, 14, 15, 30, 52, 56) formés dans la région dénudée et pénétrant à des profondeurs différentes depuis la surface supérieure du substrat, caractérisé en ce que la surface supérieure de la région à défauts en volume a un profil qu dépend du profil inférieur des éléments actifs à semi-conducteur si bien que les variations d'épaisseur de la couche dénudée comprises entre les éléments et la région à défauts en volume sont inférieurs à celles qui seraient observées si la région à défauts en volume avait une surface supérieure sensiblement plane.

2. Dispositif selon la revendication 1, caractérisé en ce que l'épaisseur de la couche dénudée entre chaque élément actif et la région adjacente à défauts en volume est pratiquement la même.

3. Dispositif selon l'une des revendications précédentes caractérisé en ce que l'un des éléments actifs à semi-conducteur est un puits P ou N (15, 30) ou un collecteur enterré P ou N (52), et la surface supérieure de la région à défauts en volume a un profil qui descend au-dessous du puits ou du collecteur.

4. Dispositif selon l'une quelconque des revendications précédentes, caractérisé eń ce que le profil inférieur d'un élément actif à semi-conducteur (5) est délimité par la couche d'épuisement (14) formée au-dessous de l'élément.

5. Dispositif selon la revendication 4, caractérisé en ce que la couche d'épuisement atteint une profondeur variable au-dessous de l'élément et la surface supérieure de la région à défauts en volume a un profil qui dépend du profil de la couche d'épuisement.

6. Dispositif selon la revendication 4 ou 5, caractérisé en ce que la distance comprise entre la région à défauts en volume et la partie la plus profonde de la couche d'épuisement est comprise entre 2 et 30 µm.

7. Dispositif selon l'une quelconque des revendications précédentes, caractérisé en ce que l'un au moins des éléments actifs à semi-conducteur fait partie d'une paire de régions ayant des types différents de conductivité et qui forment une jonction PN.

8. Dispositif selon la revendication 7 caractérisé en ce que la profondeur de la région à défauts en volume est déterminée d'après la profondeur de la région active vers laquelle les porteurs circulent à partir d'un ou plusieurs éléments à semi-conducteur pendant l'excitation du dispositif à semi-conducteur.

9. Dispositif selon l'une quelconque des revendications précédentes, caractérisé en ce que les éléments à semi-conducteur sont des transistors bipolaires, ayant de préférence des régions enterrées de collecteur.

10. Dispositif selon l'une quelconque des revendications précédentes, dans lequel les éléments à semi-conducteur sont des transistors MOS ayant une région de drain et une région de source, la profondeur de la région à défauts en volume au-dessous de la région de drain étant inférieure à sa profondeur au-dessous de la région de source, et les transistors MOS sont des préférence des transistors CMOS ayant chacun un puits P ou un puits N.

11. Procédé de fabrication d'un dispositif à semi-conducteur comportant un substrat semi-conducteur (1, 21, 51, 70, 80) ayant une région dénudée (2, 23, 26, 43, 46, 80a) dans une partie de sa surface supérieure, dans lequel plusieurs éléments actifs à semi-conducteur (4, 5, 9, 10, 14, 15, 30, 52, 56) sont formés et atteignent des profondeurs différentes par rapport à la surface supérieure du substrat semi-conducteur, et une région à défauts en volume (3, 27, 47, 71a, 72a, 80b) placée au-dessous de la région dénudée, le procédé comprenant une étape de formation sélective, dans le substrat, de la région à défauts en volume ayant une concentration élevée d'oxygène et une profondeur, mesurée à partir de la surface du substrat semi-conducteur, qui n'est pas uniforme et qui correspond au profil non uniforme voulu de profondeur des éléments à semi-conducteur, et la formation des éléments à semi-conducteur au-dessus de la région à défauts en volume.

12. Procédé selon la revendication 11, caractérisé en ce que le substrat semi-conducteur est une tranche CZ (1, 21) et l'étape de formation sélective d'une région à défauts en volume comprend la diffusion de l'oxygène contenu dans la tranche CZ vers l'extérieur par une technique de fixation intrinsèque.

13. Procédé selon la revendication 12, caractérisée en ce que la diffusion de l'oxygène vers l'extérieur est réalisée par utilisation d'un masque formé d'un film de nitrure (25) destiné à exposer sélectivement une partie de la tranche CZ (21), et la région à défauts en volume (26) est formée dans cette partie.

14. Procédé selon la revendication 11, caractérisé en ce que le substrat semi-conducteur est une tranche FZ (70), et l'étape de formation sélective d'une région à défauts en volume (71a, 72a) comporte la diffusion ou l'implantation d'ions oxygène dans la tranche FZ.

10

# Fig. 1

EP 0 070 713 B1

# Fig. 2

α RAYS

## Fig. 3

α RAYS

5

13

11

9

10

P⁺

2

N

14

N

3

## Fig. 4

5

11

19

9

10

19

N⁺

P⁺

P⁺

N⁺

2

N

14

I

N

3

**Fig. 5A**

**Fig. 5B**

**Fig. 5C**

**Fig. 5D**

*Fig. 5E*

*Fig. 5F*

*Fig. 5G*

Fig. 6 A

Fig. 6 B

Fig. 6 C

Fig. 6 D

6

*Fig. 6E*

*Fig. 6F*

*Fig. 6G*

*Fig. 7A*

*Fig. 7B*

*Fig. 7C*

*Fig. 7D*

## Fig. 8A

80a

82

81

80

## Fig. 8B

80a

83

80

## Fig. 8C

80a

83

80

80b